(19) Europäisches Patentamt European Patent Office Office européen des brevets

(11) **EP 4 031 842 B1**

(12) **EUROPÄISCHE PATENTSCHRIFT**

(45) Veröffentlichungstag und Bekanntmachung des Hinweises auf die Patenterteilung:
**14.08.2024  Patentblatt 2024/33**

(21) Anmeldenummer: **20761195.5**

(22) Anmeldetag: **20.08.2020**

(51) Internationale Patentklassifikation (IPC):
**G01F 23/284** (2006.01)    **G01N 22/00** (2006.01)
**G01R 27/26** (2006.01)

(52) Gemeinsame Patentklassifikation (CPC):
**G01F 23/2845; G01N 22/00; G01R 27/2617**

(86) Internationale Anmeldenummer:
**PCT/EP2020/073399**

(87) Internationale Veröffentlichungsnummer:
**WO 2021/052706 (25.03.2021 Gazette 2021/12)**

(54) **MESSGERÄT ZUR BESTIMMUNG EINES DIELEKTRIZITÄTSWERTES**

MEASURING DEVICE FOR DETERMINING A DIELECTRIC VALUE

DISPOSITIF DE MESURE POUR DÉTERMINER UNE VALEUR DIÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.09.2019   DE 102019124825**

(43) Veröffentlichungstag der Anmeldung:
**27.07.2022   Patentblatt 2022/30**

(73) Patentinhaber: **Endress+Hauser SE+Co. KG**
**79689 Maulburg (DE)**

(72) Erfinder:
• **BLÖDT, Thomas**
**79585 Steinen (DE)**
• **TEXTOR, Olaf**
**79540 Lörrach (DE)**

(74) Vertreter: **Koslowski, Christine Adelheid**
**Endress+Hauser Group Services**
**(Deutschland) AG+Co. KG**
**Colmarer Straße 6**
**79576 Weil am Rhein (DE)**

(56) Entgegenhaltungen:
**EP-A2- 0 622 628      WO-A1-2019/214924**
**US-A- 3 703 829      US-A- 5 898 308**
**US-B1- 6 619 117**

**Beschreibung**

Die Erfindung betrifft ein Messgerät zur Bestimmung eines Dielektrizitätswertes eines Füllgutes.

In der Automatisierungstechnik, insbesondere in der Prozessautomatisierungstechnik, werden vielfach Feldgeräte eingesetzt, die zur Erfassung und/oder zur Beeinflussung verschiedener Messgrößen dienen. Bei der zu bestimmenden Messgröße kann es sich beispielsweise um einen Füllstand, einen Durchfluss, einen Druck, die Temperatur, der pH-Wert, das Redoxpotential, eine Leitfähigkeit oder der Dielektrizitätswert eines Mediums handeln. Zur Erfassung der entsprechenden Messwerte umfassen die Feldgeräte jeweils geeignete Sensoren bzw. basieren auf geeigneten Messprinzipien. Eine Vielzahl dieser Feldgeräte wird von der Firma Endress + Hauser hergestellt und vertrieben.

Die Bestimmung des Dielektrizitätswertes (auch bekannt als *"Dielektrizitätskonstante"* oder *"Relative Permittivität")* von Füllgütern in Behältern ist sowohl bei Feststoffen, als auch bei flüssigen und gasförmigen Füllgütern, wie beispielsweise Treibstoffen, Abwässern, Gasen oder Chemikalien von großem Interesse, da dieser Wert einen zuverlässigen Indikator für Verunreinigungen, den Feuchtegehalt oder die Stoffzusammensetzung darstellen. Unter dem Begriff "Behälter" werden im Rahmen der Erfindung auch nicht-abgeschlossene Behältnisse, wie beispielsweise Becken, Seen oder fließende Gewässer verstanden.

Zur Bestimmung des Dielektrizitätswertes kann nach dem Stand der Technik vor allem bei flüssigen Füllgütern auf das kapazitive Messprinzip zurückgegriffen werden. Dabei wird der Effekt genutzt, dass sich die Kapazität eines Kondensators proportional mit dem Dielektrizitätswert desjenigen Mediums, das sich zwischen den zwei Elektroden des Kondensators befindet, ändert.

Zur Messung des Dielektrizitätswertes werden außerdem TDR-Sensoren (TDR ist ein Akronym für *"Time Domain Reflectometry"*; zu Deutsch *"Zeitbereichsreflektometrie")* eingesetzt. Bei diesem Messprinzip sendet der Sensor ein pulsförmiges Hochfrequenz-Signal mit einer Frequenz zwischen 0,1 GHz und 150 GHz entlang einer leitfähigen Mess-Sonde aus und misst die Laufzeit des Pulses bis zum Empfang des reflektierten Hochfrequenz-Signals. Dabei wird der Effekt genutzt, dass die Pulslaufzeit abhängig vom Dielektrizitätswert desjenigen Stoffes ist, der die Mess-Sonde umgibt. Beschrieben ist das Funktionsprinzip von TDR-Sensoren beispielsweise in der Veröffentlichungsschrift EP 0622 628 A2. TDR-Sensoren werden in zahlreichen Ausführungsformen beispielsweise von der Firma IMKO Mikromodultechnik GmbH vertrieben. Vorteilhaft an TDR-Sensoren ist außerdem, dass neben dem Dielektrizitätswert potentiell auch der dielektrische Verlustfaktor des Stoffes bestimmt werden kann.

Darüber hinaus ist es mittels des TDR-Prinzips auch möglich, den Dielektrizitätswert eines (flüssigen) Mediums in einem Behälter-Inneren quasi parasitär bei dessen Radar-basierter Füllstandsmessung mitzubestimmen. Auch hier werden entsprechende Hochfrequenz-Signale über eine elektrisch leitfähige Mess-Sonde in das Medium geführt werden. Beschrieben ist diese kombinierte Füllstands- und Dielektrizitäts-Messung in der Offenlegungsschrift DE 10 2015 117 205 A1. Bei TDR-basierter Füllstandsmessung erstreckt sich die Mess-Sonde Prinzip-bedingt also über die gesamte Behälter-Höhe.

Auch wenn lediglich der Dielektrizitätswert zu messen ist, kann die eine TDR-basierte Mess-Sonde gegebenenfalls nicht wesentlich kompakter ausgelegt werden, damit eine gewisse Signal-Mindestlaufzeit gewährt wird und dadurch eine hinreichend große Messgenauigkeit erreicht wird. Hierdurch besteht die Gefahr, dass TDR-basierte Dielektrizitätswert-Messgeräte im Zweifelsfall zu sperrig für gewisse Einbausituationen sind.

Der Erfindung liegt daher die Aufgabe zugrunde, ein kompakt auslegbares Dielektrizitätswert-Messgerät bereitzustellen.

Die Erfindung löst diese Aufgabe durch ein Messgerät zur Bestimmung des Dielektrizitätswertes eines Mediums, das folgende Komponenten umfasst:

- Eine Mess-Sonde mit

   ○ einem Mess-Stab, der in Kontakt mit dem Medium bringbar ist,
   ○ zumindest einer ersten elektrisch leitfähigen Elektrode, die auf dem Mess-Stab aufgewickelt ist,
   ○ einer zweiten Elektrode,

- eine Hochfrequenz-Einheit, die ausgelegt ist, ein Hochfrequenz-Signal zumindest in die erste Elektrode (111) einzukoppeln und anhand eines entsprechenden Reflexionssignals den Dielektrizitätswert des Mediums zu bestimmen, wobei die zweite Elektrode als Masse-Potential für das Hochfrequenz-Signal bzw. das Reflexionssignal dient, dass sich die zweite Elektrode innerhalb des Mess-Stabs stabförmig über zumindest denjenigen Bereich des Mess-Stabs erstreckt, in dem die erste Elektrode auf dem Mess-Stab aufgewickelt ist.

Dabei definiert sich der Begriff "Hochfrequenz" im Rahmen der Erfindung allgemein auf Signale zwischen 0,1 GHz bis hin zu 200 GHz. Je nach Messbereich ist es jedoch vorteilhaft, wenn die Hochfrequenz-Einheit ausgelegt ist, das elektrische Hochfrequenz-Signal mit einer Frequenz zwischen 0,01 GHz und 10 GHz, insbesondere zwischen 0,433 GHz und 6 GHz zu erzeugen.

Erfindungsgemäß zeichnet sich das Messgerät dadurch aus, dass die erste Elektrode auf einem Mess-Stab, der in Kontakt mit dem Medium bringbar ist, aufgewickelt ist. Vorteilhaft hieran ist, dass dadurch die Mess-Sonde deutlich kürzer ausgelegt werden kann, ohne dass die Sensitivität des Messgerätes eingeschränkt wird. Hierdurch kann das Messgerät auch bei beengten Einbauverhältnissen eingesetzt werden. Die Geometrie des Mess-Stabes ist hierbei nicht fest vorgegeben. Der Mess-Stab kann beispielsweise einen kreisförmigen oder einen rechteckigen Querschnitt aufweisen. Denkbar ist es auch, dass der Mess-Stab keine geradlinige Achse aufweist, sondern die Achse je nach Einsatzort entsprechend gekrümmt ist.

Unter dem Begriff *"Einheit"* wird im Rahmen der Erfindung prinzipiell jede elektronische Schaltung verstanden, die für den angedachten Einsatzzweck geeignet ausgelegt ist. Es kann sich also je nach Anforderung um eine Analogschaltung zur Erzeugung bzw. Verarbeitung entsprechender analoger Signale handeln. Es kann sich jedoch auch um eine Digitalschaltung wie einem FPGA oder einen Speichermedium in Zusammenwirken mit einem Programm handeln. Dabei ist das Programm ausgelegt, die entsprechenden Verfahrensschritte durchzuführen bzw. die notwendigen Rechenoperationen der jeweiligen Einheit anzuwenden. In diesem Kontext können verschiedene elektronische Einheiten des Füllstandsmessgerätes im Sinne der Erfindung potentiell auch auf einen gemeinsamen physikalischen Speicher zurückgreifen bzw. mittels derselben physikalischen Digitalschaltung betrieben werden.

Prinzipiell ist es im Rahmen der Erfindung nicht fest vorgegeben, gemäß welchem Messprinzip anhand des reflektierten Hochfrequenz-Signals der Dielektrizitätswert ermittelt wird. Es bietet sich jedoch insbesondere an, den Dielektrizitätswert mittels einem der TDR-Messprinzipien zu ermitteln. In diesen Fällen ist die Hochfrequenz-Einheit auszulegen, um das Hochfrequenz-Signal entsprechend pulsförmig zu erzeugen. Als Masse-Potential gegenüber dem Hochfrequenz-Signal kann die Mess-Sonde innerhalb des Mess-Stabs eine zweite Elektrode umfassen. Dabei kann die zweite Elektrode beispielsweise dieselbe Geometrie wie der Mess-Stab, jedoch mit entsprechend verkleinerten Abmessungen, aufweisen, also beispielsweise stabförmig mit rundem Querschnitt.

Damit das elektromagnetische Nah-Feld des Hochfrequenz-Signals verlustarm in das Medium eindringen kann, muss die erste Elektrode elektrisch vom Mess-Stab isoliert sein. Hierzu kann beispielsweise die erste Elektrode mit einer entsprechend isolierenden Ummantelung ausgelegt sein. Der Mess-Stab kann hierzu jedoch auch aus einem elektrisch nicht leitfähigen Material gefertigt werden. Zur Verstärkung des elektromagnetischen Feldes des Hochfrequenz-Signals im Medium ist es hierbei vorteilhaft, wenn das isolierende Material des Mess-Stabes ein relative Dielektrizitätszahl von zwischen 6 und 40 aufweist.

Zum Schutz des Mess-Stabes bzw. der ersten Elektrode vor Umwelteinflüssen, wie abrasiven Medien, kann der erfindungsgemäße Mess-Stab mit einer elektrisch nicht leitfähigen Beschichtung versehen werden. Sofern der Mess-Stab aus einem isolierenden Material gefertigt ist, bietet es sich in diesem Fall an, dass die elektrisch isolierende Beschichtung eine kleinere Dielektrizitätszahl als der Mess-Stab aufweist, so dass sich vom Inneren der Mess-Sonde nach außen quasi ein Gradient der Dielektrizitätszahl einstellt. Hierdurch wird wiederum das Eindringen des elektromagnetischen Feldes des Hochfrequenz-Signals in das Medium verstärkt. Dementsprechend kann die Beschichtung beispielsweise aus einem Glas, PTFE, ABS oder einer Keramik bestehen.

Da die Sensitivität der Dielektrizitätswert-Messung potentiell umso höher ist, je höher die Wicklungsdichte der ersten Elektrode um den Mess-Stab herum ist, ist es vorteilhaft, wenn die erste Elektrode entlang des Mess-Stabs eine Wicklungsdichte von mindestens 2 Wicklungen pro derjenigen Wellenlänge aufweist, die der Frequenz des Hochfrequenz-Signals entspricht.

Die Mess-Sonde des erfindungsgemäßen Messgerätes kann in solch einer Form erweitert werden, dass in etwa deckungsgleich zur ersten Elektrode auf dem Mess-Stab eine dritte Elektrode aufgewickelt ist. Dabei ist die dritte Elektrode in Bezug zum Mess-Stab innerhalb der ersten Elektrode angeordnet. Sofern die Hochfrequenz-Einheit die dritte Elektrode derart mit dem ersten Hochfrequenz-Signal ansteuert, dass die Phasenlagen des Hochfrequenz-Signals an der ersten Elektrode und der dritten Elektrode in etwa gleich sind, bietet dies den Vorteil, dass hierdurch das elektromagnetische Nahfeld des Hochfrequenz-Signals entlang der ersten Elektrode im Medium verstärkt wird und dadurch die Sensitivität der Dielektrizitätswert-Messung erhöht wird. Genutzt werden kann dieser Effekt insbesondere, wenn die dritte Elektrode eine größere Querschnittsfläche als die erste Elektrode aufweist. In diesem Zusammenhang sollte die Querschnittsfläche mindestens um 10 % größer sein, denkbar ist jedoch auch eine um bis zu 400 % größere Querschnittsfläche. Vorteilhaft ist in diesem Zusammenhang ebenfalls ein länglicher Querschnitt.

Anhand der nachfolgenden Figuren wird die Erfindung näher erläutert. Es zeigt:

Fig. 1: Ein erfindungsgemäßes Messgerät zur Dielektrizitätswert-Messung eines Mediums in einem Behälter,

Fig. 2: eine Mess-Sonde des erfindungsgemäßen Messgerätes, und

Fig. 3: eine Querschnittsansicht der erfindungsgemäßen Mess-Sonde.

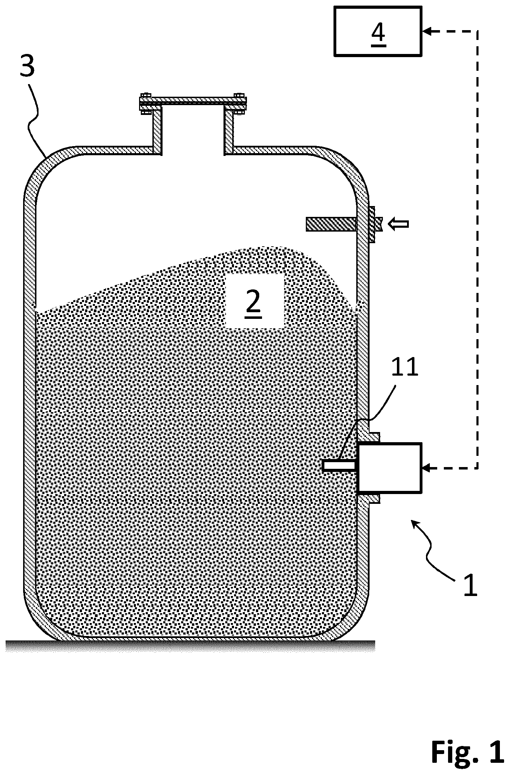

Zum allgemeinen Verständnis des erfindungsgemäßen Dielektrizitätswert-Messgerätes 1 ist in Fig. 1 eine schematische Anordnung des Messgerätes 1 an einem Behälter 3 mit einem Medium 2 gezeigt: Zur Bestimmung des Dielektrizitätswertes des Mediums 2 ist das Messgerät 1 seitlich an einem Anschluss des Behälters 2, bspw. einem Flanschanschluss angeordnet. Hierzu ist das Messgerät 1 in etwa formschlüssig zur Behälter-Innenwand angebracht. Bei dem Medium 2 kann es sich um Flüssigkeiten wie Getränke, Lacke, Zement oder Treibstoffe, wie Flüssiggase oder Mineralöle handeln. Denkbar ist jedoch auch die Verwendung des Messgerätes 1 bei Schüttgutförmigen Medien 2, wie bspw. Getreide.

Das Messgerät 1 kann mit einer übergeordneten Einheit 4 wie zum Beispiel einem Prozessleitsystem verbunden sein. Als Schnittstelle kann etwa "PROFIBUS", "HART", "Wireless HART" oder "Ethernet" implementiert sein. Hierüber kann der Dielektrizitätswert als Betrag, oder komplexwertig mit Realteil und Imaginärteil übermittelt werden. Es können aber auch anderweitige Informationen über den allgemeinen Betriebszustand des Messgerätes 1 kommuniziert werden.

Wie in Fig. 1 schematisch dargestellt ist, umfasst das erfindungsgemäße Messgerät 1 eine Mess-Sonde 11, die sich nach der Installation in das Innere des Behälters 3 erstreckt. Hierdurch ist die Mess-Sonde 11 bei entsprechendem Mindest-Füllstand des Mediums 2 in Kontakt mit dem Medium 2, so dass das Messgerät 1 über die Mess-Sonde 11 den Dielektrizitätswert des Mediums 2 ermitteln kann.

Grundlegend basiert die Funktionsweise des Messgerätes 1 auf einer Mess-Sonde 11, in die ein Hochfrequenz-Signal $s_{HF}$ eingeprägt wird, so dass das elektromagnetische Nah-Feldes des Hochfrequenz-Signals $s_{HF}$ in das Medium 2 eindringt. Hierzu umfasst die Mess-Sonde 11 eine erste, elektrisch leitfähige Elektrode 111, in welche eine Hochfrequenz-Einheit des Messgerätes 1 das Hochfrequenz-Signal $s_{HF}$ einkoppeln kann. Anhand eines am Ende der ersten Elektrode 111 entsprechend reflektierten Signals $r_{HF}$ kann der Dielektrizitätswert durch die Hochfrequenz-Einheit bestimmt werden. Die Frequenz $f_{HF}$ des Hochfrequenz-Signals $s_{HF}$ ist auf den konkreten Typ an Medium 2 bzw. den konkreten Wertebereich des zu messenden Dielektrizitätswertes anzupassen. Für Medien 2, die einen hohen Wasseranteil aufweisen, bietet sich dementsprechend eine Frequenz $f_{HF}$ zwischen 0,433 GHz und 6 GHz an.

Prinzipiell ist es im Rahmen der Erfindung nicht fest vorgegeben, gemäß welchem Messprinzip anhand des reflektierten Signals $r_{HF}$ der Dielektrizitätswert ermittelt wird. Denn der Dielektrizitätswert kann je nach Auslegung sowohl die Laufzeit, die Amplituden-Dämpfung als auch die Phasenverschiebung zum ausgesendeten Hochfrequenz-Signal $s_{HF}$ beeinflussen.

Im Falle der Signallaufzeit kann analog zum geführten Radar beispielsweise das FMCW-Verfahren (*"Frequency Modulated Continuos Wave"*) oder eine Variante des TDR-Verfahrens (*"Time Domain Reflectometry"*) implementieren.

Im Fall von FMCW kann die Hochfrequenz-Einheit zur Erzeugung des Hochfrequenz-Signals $s_{HF}$ dementsprechend einen "Phasenregelkreis" (im englischen als "Phase *Locked Loop, PLL"* bekannt) umfassen. Dieser basiert auf einem steuerbaren, elektrischen Hochfrequenz-Oszillator (standartmäßig als VCO realisiert), der das elektrische Hochfrequenz-Signal $s_{HF}$ erzeugt. Die Frequenz des Hochfrequenz-Signals $s_{HF}$ wird hierbei per Rückkopplung geregelt und somit einerseits gegenüber Schwankungen der Umgebungstemperatur stabilisiert; Andererseits wird über die Rückkopplung die bei FMCW typische, sägezahnförmige Frequenzänderung des Hochfrequenz-Signals $s_{HF}$ eingestellt: Die Rückkopplung wird realisiert, indem aus dem Hochfrequenz-Signal $s_{HF}$ des Hochfrequenz-Oszillators ein Regelsignal abgezweigt und einem Phasenkomparator zugeführt wird. Der Phasenkomparator vergleicht wiederum die momentane Phasenverschiebung des Regelsignals $s_c$ zu einem frequenzkonstanten Referenzsignal. Das Referenzsignal weist hierbei eine exakt voreinstellbare Referenzfrequenz mit vernachlässigbarem Temperaturdrift auf.

Die Laufzeit und somit den Dielektrizitätswert kann die Hochfrequenz-Einheit im Falle von FMCW beispielsweise durch Mischen des ausgesendeten Hochfrequenz-Signals $s_{HF}$ mit dem am Ende der ersten Elektrode 111 reflektierten Signal $r_{HF}$ bestimmen, da sich die Frequenz des gemischten Signals linear mit der Laufzeit ändert.

Bei Implementierung des TDR-Verfahrens kann die Hochfrequenz-Einheit zur zyklisch pulsförmigen Erzeugung des Hochfrequenz-Signals $s_{HF}$ beispielsweise einen entsprechend zyklisch angesteuerten Oszillator, beispielsweise wiederum einen spannungsgesteuerten Oszillator oder lediglich einen Quarzoszillator, umfassen. Zur Bestimmung der Laufzeit bzw. des Dielektrizitätswertes kann die Hochfrequenz-Einheit das reflektierte Signal $r_{HF}$ gemäß dem Puls-Laufzeit-Verfahren durch Unterabtastung verarbeiten. Durch die Unterabtastung wird das reflektierte Signal $r_{HF}$ in der Zeitachse gedehnt, so dass das Signal-Maximum, welches zur Signal-Laufzeit korrespondiert, schaltungstechnisch vereinfacht ermittelt werden kann.

Trotz einer etwaigen Zeitdehnung muss die erste Elektrode 111 eine definierte Mindestlänge aufweisen, damit die Hochfrequenz-Einheit die Signallaufzeit des (reflektierten) Hochfrequenz-Signals $s_{HF}$, $r_{HF}$, bzw. die Laufzeit-Änderung in Abhängigkeit verschiedener Medien 2 mit verschiedenen Dielektrizitätswerten mit hinreichender Auflösung bestimmen kann. In der Praxis führt dies dazu, dass die Mess-Sonde 11 eine entsprechende MindestLänge aufweisen muss. Hierdurch kann das Messgerät 1 jedoch je nach Einbausituation oder Behältergröße zu sperrig für die jeweilige Anwendung ausfallen.

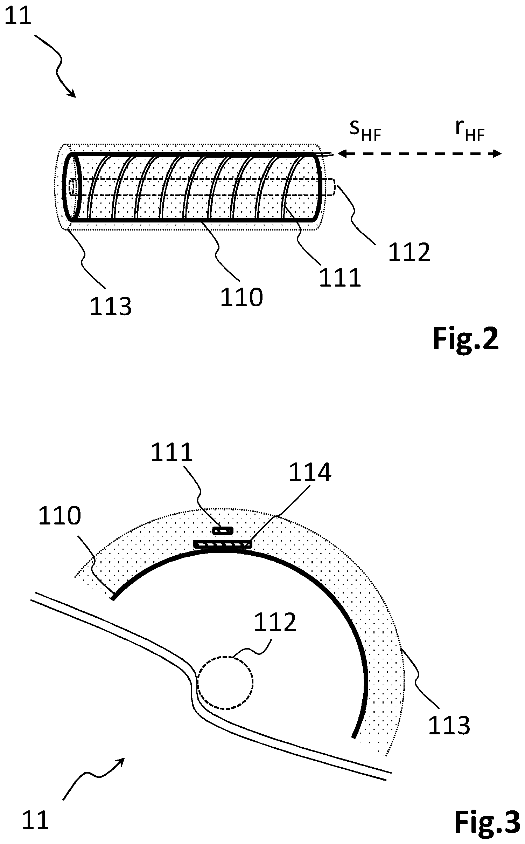

Auf Basis der erfindungsgemäßen Mess-Sonde 11, wie sie in Fig. 2 gezeigt ist, kann das Messgerät 1 deutlich kompakter ausgelegt werden: Wie dargestellt, ist die erste Elektrode 111 hierzu auf einem Mess-Stab 110 aufgewickelt, wobei der Mess-Stab 110 elektrisch von der ersten Elektrode 111 isoliert ist. Zwecks Isolation kann die erste Elektrode 111 beispielsweise als ummanteltes Cu- oder Au-Kabel ausgelegt sein, oder der Mess-Stab 110 kann hierzu auch aus einem elektrisch nicht leitfähigen Material gefertigt sein.

Je höher die Wicklungsdichte der ersten Elektrode 111 um den Mess-Stab 110 herum ist, desto höher ist potentiell auch die Sensitivität der Dielektrizitätswert-Messung. Mindestens ist die Wicklungsdichte $\#_{min}$ jedoch so auszulegen, dass die erste Elektrode 111 entlang des Mess-Stabs 110 eine Wicklungsdichte $\#_{min}$ von mindestens 2 Wicklungen pro derjenigen Wellenlänge $\lambda_{HF}$ aufweist, die der Frequenz $f_{HF}$ des Hochfrequenz-Signals $s_{HF}$ entspricht, gemäß:

$$\lambda_{HF} = \frac{c}{f_{HF}}$$

(c ist hierbei die Ausbreitungsgeschwindigkeit elektromagnetischer Wellen mit ca. $3*10^8$ m/s). Daraus folgt für die Mindest- Wicklungsdichte $\#_{min}$:

$$\#_{min} \sim 2 * \frac{f_{HF}}{c}$$

Bei einer Frequenz $f_{HF}$ des Hochfrequenz-Signals $s_{HF}$ von 1 GHz entspricht die Mindest-Wicklungsdichte $\#_{min}$ gemäß dieser Formel somit ungefähr 20 Wicklungen pro Meter.

Bei der in Fig. 2 gezeigten Ausführungs-Variante weist der Mess-Stab 110 eine gerade Achse und einen kreisförmigen Querschnitt auf. Allgemein ist die Querschnittsform im Rahmen der Erfindung jedoch nicht fest vorgeschrieben und kann beispielsweise auch rechteckig sein. Auch die Achse des Mess-Stabs 110 kann im Gegensatz zu der gezeigten Ausführungsvariante gekrümmt sein, sofern es der Einsatzort erfordern sollte.

Als Masse-Potential gegenüber dem (reflektierten) Hochfrequenz-Signal $s_{HF}$, $r_{HF}$ umfasst die Mess-Elektrode 11 bei der in Fig. 2 gezeigten Ausführungsvariante bezogen auf den Querschnitt im Kreismittelpunkt des Mess-Stabes 110 eine stabförmige zweite Elektrode 112 mit ebenfalls rundem Querschnitt, wobei die zweite Elektrode 112 wiederum elektrisch vom Mess-Stab 110 isoliert ist. Dabei ist die zweite Elektrode 112 lang genug ausgelegt, um sich zumindest über denjenigen Bereich des Mess-Stabs 110 zu erstrecken, in dem die erste Elektrode 111 auf dem Mess-Stab 110 aufgewickelt ist.

Bei der in Fig. 2 dargestellten Ausführungsvariante der Mess-Sonde 11 ist auf dem Mess-Stab 110 bzw. um die erste Elektrode 111 herum eine elektrisch isolierende Beschichtung 113 aufgebracht. Die Beschichtung 113 dient dabei primär dem mechanischen bzw. chemischen Schutz der ersten Elektrode 111 vor äußeren Einflüssen. Damit der Dielektrizitätswert des zu untersuchenden Mediums 2 dennoch hinreichend Einfluss auf das elektromagnetische Feld des Hochfrequenz-Signals $s_{HF}$ entlang der ersten Elektrode 111 hat, ist es vorteilhaft, wenn die Beschichtung 113 eine kleinere Dielektrizitätszahl als der elektrisch ebenfalls isolierende Mess-Stab 1110 aufweist. Sofern der Mess-Stab 110 also aus einem Material mit einer relativen Dielektrizitätszahl zwischen 6 und 40 $F*m^{-1}$ aufgebaut ist, kann die elektrisch isolierende Beschichtung 113 beispielsweise aus einem Material wie Glas, PTFE, ABS oder einer Keramik gefertigt werden, das eine entsprechend kleinere relative Dielektrizitätszahl als der Mess-Stab 110 aufweist.

In Fig. 3 ist eine Querschnittsansicht der erfindungsgemäßen Mess-Sonde 11 dargestellt: In dieser Ansicht ist eine erweiterte Ausführungsvariante dargestellt, bei der in etwa deckungsgleich zur ersten Elektrode 111 auf dem Mess-Stab 110 eine dritte Elektrode 114 aufgewickelt ist. Dabei ist die dritte Elektrode 114 in Bezug zum Mess-Stab 110 innerhalb der ersten Elektrode 111 angeordnet.

Sowohl die erste Elektrode 111 als auch die dritte Elektrode 114 weisen in der gezeigten Darstellung in Bezug zum Querschnitt des Mess-Stabes 10 einen länglichen Querschnitt auf. Dabei sind die Länge und somit die Querschnittsfläche der dritten Elektrode 114 um ca. 150 % größer als die Querschnittsfläche der ersten Elektrode 111. Diese Ausführungsvariante der Mess-Sonde 11 ermöglicht es, das elektromagnetische Feld des Hochfrequenz-Signals $s_{HF}$ entlang der ersten Elektrode 111 mit erhöhter Intensität in das zu untersuchende Medium 2 einzuprägen. Hierdurch kann wiederum die Sensitivität der Messung erhöht werden. Voraussetzung ist hierfür, dass die Hochfrequenz-Einheit des Messgerätes 1 auch an der dritten Elektrode 114 das Hochfrequenz-Signal $s_{HF}$ einprägt, und zwar ungefähr phasengleich zur ersten Elektrode 111. Durch die dritte Elektrode 114 kann somit die Baugröße der Mess-Sonde 11 potentiell weiter verkleinert werden, ohne die Sensitivität zu vermindern. Die Sensitivität, bzw. die Ausdehnung des Messbereichs um die Mess-Sonde 11 kann wiederum über die Signalstärke, mit der das Hochfrequenz-Signal $s_{HF}$ in die dritte Elektrode 114 eingeprägt wird, variabel eingestellt werden.

**Bezugszeichenliste**

| | |
|---|---|
| 1 | Messgerät |
| 2 | Medium |
| 3 | Behälter |
| 4 | Übergeordnete Einheit |
| 11 | Mess-Sonde |
| 110 | Mess-Stab |
| 111 | Erste Elektrode |
| 112 | Zweite Elektrode |
| 113 | Beschichtung |
| 114 | Dritte Elektrode |
| $f_{HF}$ | Frequenz des Hochfrequenz-Signals |
| $r_{HF}$ | Reflektiertes Signal |
| $s_{HF}$ | Hochfrequenz-Signal |
| $\#_{min}$ | Mindest-Wicklungsdichte |
| $\lambda_{HF}$ | Korrespondierende Wellenlänge des Hochfrequenz-Signals |

**Patentansprüche**

1. Messgerät zur Bestimmung des Dielektrizitätswertes eines Mediums (2), umfassend:

  - Eine Mess-Sonde (11) mit

    o einem Mess-Stab (110), der in Kontakt mit dem Medium (2) bringbar ist,
    o zumindest einer ersten elektrisch leitfähigen Elektrode (111), die auf dem Mess-Stab (110) aufgewickelt ist,
    o einer zweiten Elektrode (112),

  - eine Hochfrequenz-Einheit, die ausgelegt ist, ein Hochfrequenz-Signal ($s_{HF}$) zumindest in die erste Elektrode (111) einzukoppeln und anhand eines entsprechenden Reflexionssignals ($r_{HF}$) den Dielektrizitätswert (DK) des Mediums (2) zu bestimmen, **dadurch gekennzeichnet, dass** die zweite Elektrode (112) als Masse-Potential für das Hochfrequenz-Signal ($s_{HF}$) bzw. das Reflexionssignal ($r_{HF}$) dient,

  **dass** sich die zweite Elektrode (112) innerhalb des Mess-Stabs (110) stabförmig über zumindest denjenigen Bereich des Mess-Stabs (110) erstreckt, in dem die erste Elektrode (111) auf dem Mess-Stab (110) aufgewickelt ist.

2. Messgerät nach Anspruch 1, wobei die Hochfrequenz-Einheit ausgelegt ist, das Hochfrequenz-Signal ($s_{HF}$) derart pulsförmig zu erzeugen, dass der Dielektrizitätswert anhand eines Zeitbereichsreflektometrie- Messprinzips, TDR-Messprinzips, ermittelbar ist.

3. Messgerät nach einem der vorhergehenden Ansprüche, wobei der Mess-Stab (110) einen kreisförmigen Querschnitt aufweist.

4. Messgerät nach einem der vorhergehenden Ansprüche, wobei der Mess-Stab (110) eine elektrisch nicht leitfähige Beschichtung (113) umfasst.

5. Messgerät nach einem der vorhergehenden Ansprüche, wobei der Mess-Stab (110) aus einem elektrisch nicht leitfähigen Material gefertigt ist, das eine definierte relative Dielektrizitätszahl zwischen 6 und 40 aufweist.

6. Messgerät nach Anspruch 5, wobei die elektrisch isolierende Beschichtung (113) eine kleinere Dielektrizitätszahl als der Mess-Stab (110) aufweist und insbesondere aus einem Glas, PTFE, ABS oder einer Keramik gefertigt ist.

7. Messgerät nach einem der vorhergehenden Ansprüche, wobei die erste Elektrode (111) entlang des Mess-Stabs (110) eine Wicklungsdichte #$_{min}$ von mindestens 2 Wicklungen pro derjenigen Wellenlänge ($\lambda_{HF}$) aufweist, die der Frequenz ($f_{HF}$) des Hochfrequenz-Signals ($s_{HF}$) entspricht.

8. Messgerät nach einem der vorhergehenden Ansprüche, wobei in etwa deckungsgleich zur ersten Elektrode (111) auf dem Mess-Stab (110) eine dritte Elektrode (114) aufgewickelt ist, die in Bezug zum Mess-Stab (110) innerhalb der ersten Elektrode (111) angeordnet ist und eine größere Querschnittsfläche als die erste Elektrode (111) aufweist.

9. Messgerät nach Anspruch 8, wobei die Hochfrequenz-Einheit die dritte Elektrode (114) derart mit dem ersten Hochfrequenz-Signal ($s_{HF}$) ansteuert, dass die Phasenlagen des Hochfrequenz-Signals ($s_{HF}$) an der ersten Elektrode (111) und der dritten Elektrode (114) in etwa gleich sind.

10. Messgerät nach zumindest einem der vorhergehenden Ansprüche, wobei die Hochfrequenz-Einheit ausgelegt ist, das elektrische Hochfrequenz-Signal ($s_{HF}$) mit einer Frequenz zwischen 0,1 GHz und 10 GHz zu erzeugen.

**Claims**

1. A measuring device for determining the dielectricity value of a medium (2), comprising:

  - A measurement probe (11) with

    o a measurement rod (110), which can be brought into contact with the medium (2),
    o at least a first electrically conductive electrode (111), which is wound onto the measurement rod (110),
    o a second electrode (112),

  - a high-frequency unit, which is configured to couple a high-frequency signal (SHF) at least into the first electrode (111) and to determine the dielectricity value (DK) of the medium (2) based on a corresponding reflection signal ($r_{HF}$), **characterized in that** the second electrode (112) is used as ground potential for the high-frequency signal (SHF) or the reflection signal ($r_{HF}$) and **in that** the second electrode (112) inside the measurement rod (110) extends in the shape of a rod at least over the area of the measurement rod (110) in which the first electrode (111) is wound onto the measurement rod (110).

2. The measuring device as claimed in claim 1, wherein the high-frequency unit is configured to generate the high-frequency signal ($s_{HF}$) in the form of pulses in such a way that the dielectricity value can be determined based on a time-domain reflectometry (TDR) measuring principle.

3. The measuring device as claimed in one of the preceding claims, wherein the measurement rod (110) has a circular cross-section.

4. The measuring device as claimed in one of the preceding claims, wherein the measurement rod (110) has a coating which does not conduct electricity (113).

5. The measuring device as claimed in one of the preceding claims, wherein the measurement rod (110) is made from a material which does not conduct electricity and has a defined relative dielectric constant of between 6 and 40.

6. The measuring device as claimed in claim 5, wherein the electrically insulating coating (113) has a lower dielectric constant than the measurement rod (110) and in particular is made from glass, PTFE, ABS or a ceramic.

7. The measuring device as claimed in one of the preceding claims, wherein the first electrode (111) along the measurement rod (110) has a winding density #min of at least two coils per wavelength (AHF) that corresponds to the frequency ($f_{HF}$) of the high-frequency signal ($s_{HF}$).

8. The measuring device as claimed in one of the preceding claims, wherein a third electrode (114) is wound onto the measurement rod (110) such that it is approximately congruent with the first electrode (111), said third electrode (114) being arranged inside the first electrode (111) relative to the measurement rod (110) and having a larger cross-sectional area than then first electrode (111).

9. The measuring device as claimed in claim 8, wherein the high-frequency unit actuates the third electrode (114) in such a way with the first high-frequency signal ($s_{HF}$) that the phase positions of the high-frequency signal ($s_{HF}$) are approximately identical at the first electrode (111) and at the third electrode (114).

10. The measuring device as claimed in at least one of the preceding claims, wherein the high-frequency unit is configured to generate the electrical high-frequency signal ($s_{HF}$) with a frequency between 0.1 GHz and 10 GHz.

## Revendications

1. Appareil de mesure destiné à la détermination de la constante diélectrique d'un produit, lequel appareil comprend :

   - une sonde de mesure (11) avec

     ◦ une tige de mesure (110) pouvant être mise en contact avec le produit (2),
     ◦ au moins une première électrode électriquement conductrice (111), laquelle est enroulée sur la tige de mesure (110) ;
     ◦ une deuxième électrode (112),

   - une unité haute fréquence, laquelle est conçue pour injecter un signal haute fréquence ($s_{HF}$) au moins dans la première électrode (111) et pour déterminer la constante diélectrique (DK) du produit (2) à l'aide d'un signal de réflexion ($r_{HF}$) correspondant,

   **caractérisé**

   **en ce que** la deuxième électrode (112) sert de potentiel de masse pour le signal haute fréquence ($s_{HF}$) ou le signal de réflexion ($r_{HF}$) ;
   **en ce que** la deuxième électrode (112) s'étend en forme de tige à l'intérieur de la tige de mesure (110) sur au moins la zone de la tige de mesure (110) dans laquelle la première électrode (111) est enroulée sur la tige de mesure (110).

2. Appareil de mesure selon la revendication 1, pour lequel l'unité haute fréquence est conçue pour générer le signal haute fréquence ($s_{HF}$) sous forme d'impulsions de telle sorte que la constante diélectrique puisse être déterminée à l'aide d'un principe de mesure de réflectométrie dans le domaine temporel (principe de mesure TDR).

3. Appareil de mesure selon l'une des revendications précédentes, pour lequel la tige de mesure (110) présente une section transversale circulaire.

4. Appareil de mesure selon l'une des revendications précédentes, pour lequel la tige de mesure (110) comprend un revêtement électriquement non conducteur (113).

5. Appareil de mesure selon l'une des revendications précédentes, pour lequel la tige de mesure (110) est fabriquée dans un matériau électriquement non conducteur, lequel présente une constante diélectrique relative définie comprise entre 6 et 40.

6. Appareil de mesure selon la revendication 5, pour lequel le revêtement électriquement isolant (113) présente une constante diélectrique inférieure à celle de la tige de mesure (110) et lequel revêtement est notamment fabriqué à partir d'un verre, de PTFE, d'ABS ou d'une céramique.

7. Appareil de mesure selon l'une des revendications précédentes, pour lequel la première électrode (111) présente, le long de la tige de mesure (110), une densité de bobinage $\#_{min}$ d'au moins 2 bobinages par longueur d'onde ($\lambda_{HF}$) correspondant à la fréquence ($f_{HF}$) du signal haute fréquence ($s_{HF}$).

8. Appareil de mesure selon l'une des revendications précédentes, pour lequel une troisième électrode (114) est enroulée sur la tige de mesure (110) sensiblement en coïncidence avec la première électrode (111), ladite troisième électrode (114) étant disposée à l'intérieur de la première électrode (111) par rapport à la tige de mesure (110) et présentant une surface de section transversale supérieure à celle de la première électrode (111).

9. Appareil de mesure selon la revendication 8, pour lequel l'unité haute fréquence commande la troisième électrode (114) avec le premier signal haute fréquence ($s_{HF}$) de telle sorte que les positions de phase du signal haute fréquence ($s_{HF}$) sur la première électrode (111) et sur la troisième électrode (114) sont à peu près identiques.

10. Appareil de mesure selon au moins l'une des revendications précédentes, pour lequel l'unité haute fréquence est conçue pour générer le signal haute fréquence électrique ($s_{HF}$) à une fréquence comprise entre 0,1 GHz et 10 GHz.

**Fig. 1**

11

$s_{HF}$    $r_{HF}$

112

111

113    110

**Fig.2**

111    114

110

112

113

11    **Fig.3**

EP 4 031 842 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0622628 A2

- DE 102015117205 A1